# EUROPEAN PATENT APPLICATION

(11) **EP 3 379 568 A1**
(43) Date of publication of application: **26.09.2018**
(21) Application number: 17162153.5
(22) Date of filing: 21.03.2017
(51) Int. Cl.: H01L 21/673

(54) **WAFER CASSETTE AND A METHOD OF FORMING THE SAME**

(71) Applicant: Himax Technologies Limited, Tainan City 74148 (TW)
(72) Inventor: CHANG, Jui Tang, 74148 Tainan City (TW); LU, Fang Wan, 74148 Tainan City (TW)
(74) Representative: Karakatsanis, Georgios

(57) **Abstract**

A wafer cassette includes a front plate and a rear plate disposed opposite to face each other; and at least two top elongated rods, at least two middle elongated rods and at least two bottom elongated rods, each having a plurality of grooves shaped thereinto. The top elongated rods, the middle elongated rods and the bottom elongated rods each has two ends being pivotally connected to the front plate and the rear plate, respectively. The top elongated rods, the middle elongated rods and the bottom elongated rods each comprises a solid-iron rod enclosed with a cladding layer.

## Description

### BACKGROUND OF THE INVENTION

### 1. FIELD OF THE INVENTION

The present invention generally relates to a wafer cassette, and more particularly to a wafer cassette with improved structure, and enhanced precision and strength.

### 2. DESCRIPTION OF RELATED ART

A wafer cassette is a device that is capable of holding wafers to allow the wafers to be transferred between machines for processing or measurement. The wafers stored in the wafer cassette may be taken out of or be placed into the wafer cassette by a robotic hand or fork.

Conventional wafer cassettes usually suffer from reduced precision or strength after a long period of operation. For example, the precision or the strength of the wafer cassettes may be disadvantageously reduced due to thermal expansion and contraction.

Conventional wafer cassettes have a defective or inadequate structure, by which a robotic hand, particularly the front end of the robotic hand, may unexpectedly hit a lower side of the wafer cassettes and flips over the wafers due to misalignment.

For the reasons that conventional wafer cassettes suffer reduced precision and strength and have defective structure, a need has thus arisen to propose a novel wafer cassette with improved structure, and enhanced precision and strength.

### SUMMARY OF THE INVENTION

In view of the foregoing, it is an object of the embodiment of the present invention to provide a wafer cassette for storing and transporting wafers. The wafer cassette of the embodiment has enhanced precision and strength over the conventional wafer cassettes, and is capable of preventing a robotic hand from unexpectedly hitting the wafer cassette.

According to one embodiment, a wafer cassette includes a front plate and a rear plate disposed opposite to face each other; and at least two top elongated rods, at least two middle elongated rods and at least two bottom elongated rods, each having a plurality of grooves shaped thereinto. The top elongated rods, the middle elongated rods and the bottom elongated rods each has two ends being pivotally connected to the front plate and the rear plate, respectively. The top elongated rods, the middle elongated rods and the bottom elongated rods each comprises a solid-iron rod enclosed with a cladding layer.

According to another embodiment, a method of forming a wafer cassette is disclosed. A plurality of solid-iron rods are enclosed with a cladding layer by injection moulding process, thereby resulting at least two top elongated rods, at least two middle elongated rods and at least two bottom elongated rods. Two ends of each of the top elongated rods, the middle elongated rods and the bottom elongated rods are pivotally connected to a front plate and a rear plate, respectively. The front plate and the rear plate are disposed opposite to face each other.

### BRIEF DESCRIPTION OF THE DRAWINGS

FIG. 1 shows a perspective view illustrating a wafer cassette for storing and transporting wafers according to one embodiment of the present invention;
FIG. 2 shows another perspective view of the wafer cassette of FIG. 1;
FIG. 3 shows an enlarged partial view of the top elongated rods, the middle elongated rods and the bottom elongated rods of FIG. 2;
FIG. 4A shows a cross sectional view of the top elongated rod of FIG. 1/2; and
FIG. 4B shows a cross sectional view of the middle elongated rod and the bottom elongated rod of FIG. 1/2.

### DETAILED DESCRIPTION OF THE INVENTION

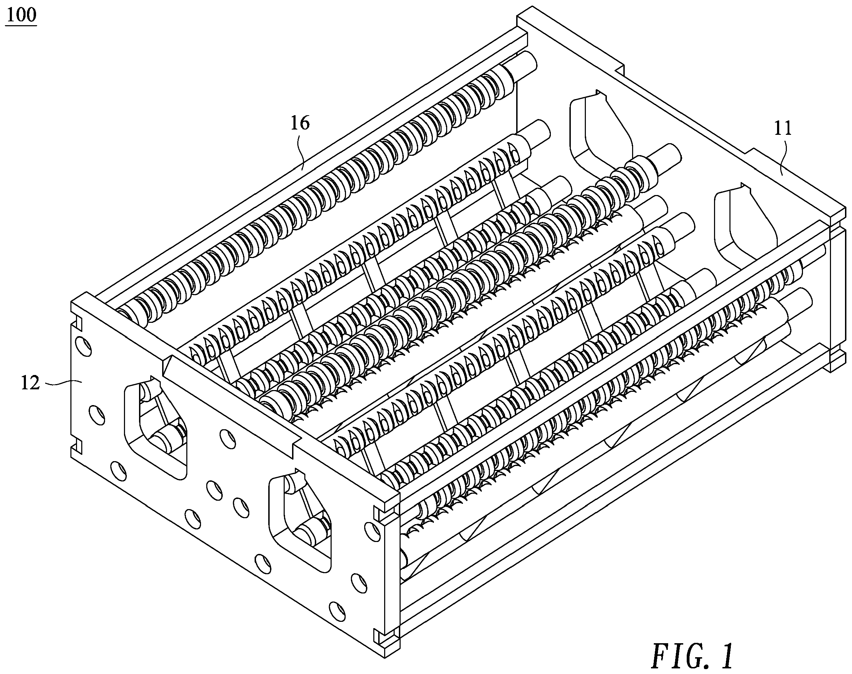

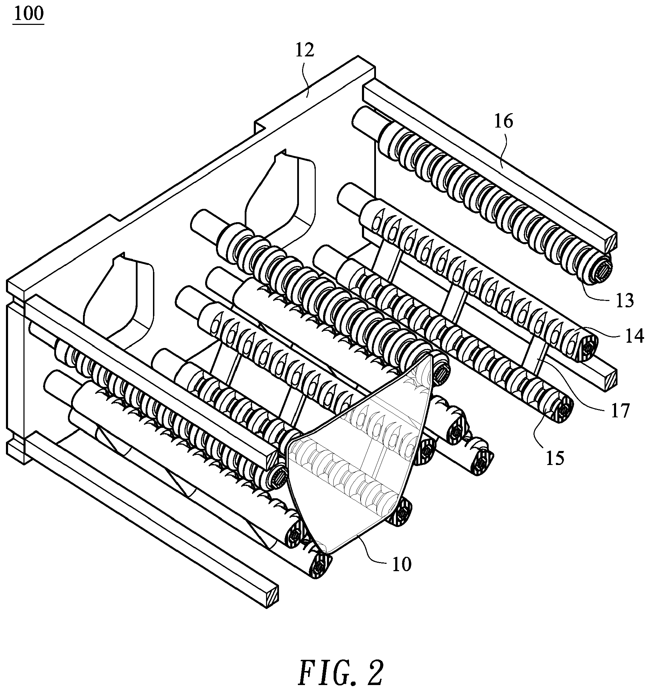

FIG. 1 shows a perspective view illustrating a wafer cassette 100 for storing and transporting wafers according to one embodiment of the present invention. FIG. 2 shows another perspective view of the wafer cassette 100 of FIG. 1 holding a wafer 10, such as an optical component (e.g., an optical lens or glass), but leaving out some components for a better view of the inside of the wafer cassette 100.

In the embodiment, the wafer cassette 100 may include a front plate 11 and a rear plate 12, which are disposed opposite to face each other. The wafer cassette 100 of the embodiment may also include at least two top elongated rods 13, at least two middle elongated rods 14 and at least two bottom elongated rods 15. The top elongated rod 13, the middle elongated rod 14 and the bottom elongated rod 15 each has a plurality of grooves shaped into the top/middle/bottom elongated rod 13/14/15. It is noted that the grooves may entirely encircle or may partially surround the top/middle/bottom elongated rod 13/14/15.

In the embodiment illustrated in FIG. 1/2, two rows of wafer cassette are provided side by side. In this case, one of the top elongated rods 13 is shared between the two rows of wafer cassette, while each row of wafer cassette has its own middle elongated rods 14 and bottom elongated rods 15.

The top elongated rod 13, the middle elongated rod 14 and the bottom elongated rod 15 each has two ends being pivotally connected to the front plate 11 and the rear plate 12, respectively. Accordingly, the top elongated rods 13, the middle elongated rods 14 and the bottom elongated rods 15 are disposed in sequence from top to bottom.

In one embodiment, the middle elongated rod 14 and the bottom elongated rod 15 disposed at the same side are further connected together with at least one connecting element 17 (three are exemplified in this case) to fixedly tighten them, thereby enhancing precision of the wafer cassette 100.

The wafer cassette 100 of the embodiment may also include four fastening rods 16 disposed at four corners of the front plate 11 and the rear plate 12 to tighten the wafer cassette 100 more firmly, thereby enhancing strength of the wafer cassette 100. The four fastening rods 16 each has two ends being pivotally connected to the front plate 11 and the rear plate 12, respectively.

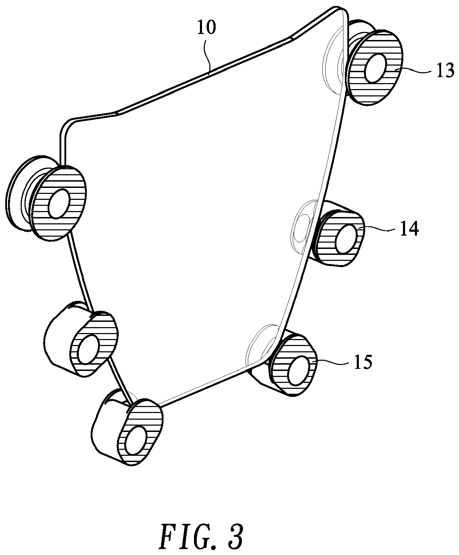

FIG. 3 shows an enlarged partial view of the top elongated rods 13, the middle elongated rods 14 and the bottom elongated rods 15 of FIG. 2 holding the wafer 10. According to one aspect of the embodiment, the bottom of the wafer 10 is supportively held at two points (i.e., the bottom elongated rods 15), instead of one point. The benefit of designing the wafer cassette 100 with two (instead of one) bottom elongated rods 15 disposed apart is that a front end of a robotic hand (not shown) will not bounce to flip over the wafer 10 in case that the front end of the robotic hand, due to misalignment, unexpectedly hits a single bottom elongated rod disposed midway.

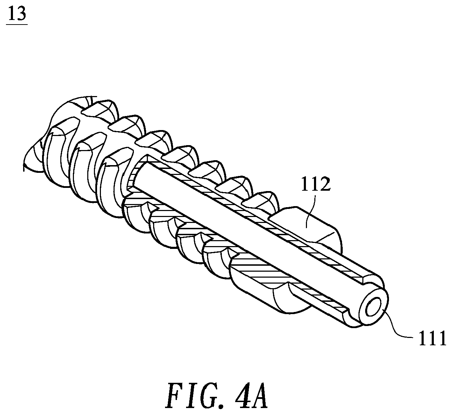

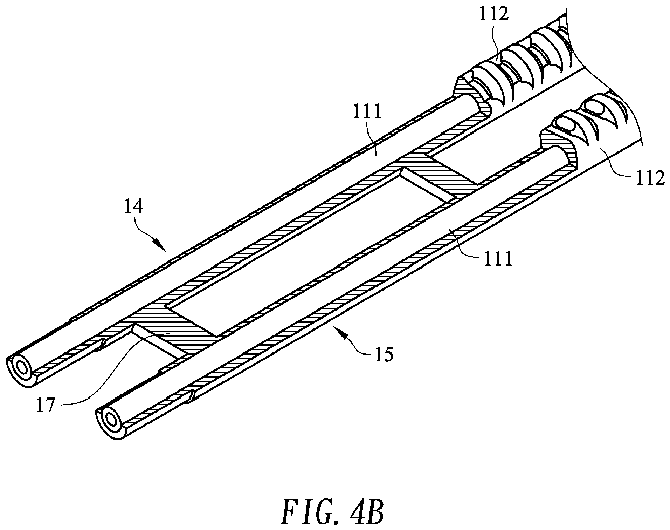

FIG. 4A shows a cross sectional view of the top elongated rod 13 of FIG. 1/2, and FIG. 4B shows a cross sectional view of the middle elongated rod 14 and the bottom elongated rod 15 of FIG. 1/2. According to another aspect of the embodiment, the top/middle/bottom elongated rod 13/14/15 may include a solid-iron rod 111 enclosed with a cladding layer 112 made of a polymer. Polyether ether ketone (PEEK) is preferred to make up the cladding layer 112 in the embodiment because of its excellent mechanical and chemical resistance properties that are retained to high temperatures and resistant to thermal expansion and contraction. Making the top/middle/bottom elongated rod 13/14/15 by using the solid-iron rod 111 enclosed with the PEEK cladding layer 112 beneficially enhances strength and precision of the wafer cassette 100, and prevents peeling or warping. In a further embodiment, the surface of the solid-iron rod 111 may be subject to texture treatment, prior to enclosing the cladding layer 112, to make deviations from a smooth surface, affecting interaction between the solid-iron rod 111 and the cladding layer 112, thereby further preventing the cladding layer 112 from peeling.

In the embodiment, the solid-iron rod 111 is a polygon solid-iron rod (preferably an octagon solid-iron rod). As the solid-iron rod 111 has a polygon (e.g., octagon) cross section, instead of a round cross section, the wafer 10 may come into contact with the top/middle/bottom elongated rods 13/14/15 by line contact but not point contact, therefore lessening stress concentration and preventing wafer chipping. Moreover, the front plate 11 and the rear plate 12 have hollows cut thereinto at places where the top/middle/bottom elongated rods 13/14/15 are pivotally connected to the front plate 11 and the rear plate 12. Particularly, the hollows have a shape corresponding to the polygon cross section of the solid-iron rod 111. Accordingly, the wafer 10 may controllably touch the top/middle/bottom elongated rods 13/14/15 precisely.

According to a further aspect of the embodiment, the cladding layer 112 enclosing the solid-iron rod 111 is integrally formed by injection moulding process. Specifically, the solid-iron rod 111 is subjected to injection moulding by injecting cladding material such as PPEK over the solid-iron rod 111 into a mould with grooves shape, therefore resulting in a plurality of grooves shaped into the cladding layer 112 that encloses the solid-iron rod 111. Accordingly, the cladding layer 112 of the embodiment not only enhances strength and precision of the wafer cassette 100, but also prevents peeling or warping, compared with the conventional cassettes having a PPEK rod that is subjected to cutting, for example, by a computer numeric control (CNC) tool.

Although specific embodiments have been illustrated and described, it will be appreciated by those skilled in the art that various modifications may be made without departing from the scope of the present invention, which is intended to be limited solely by the appended claims.

## Claims

1. A wafer cassette comprising:
a front plate and a rear plate disposed opposite to face each other; and
at least two top elongated rods, at least two middle elongated rods and at least two bottom elongated rods, each having a plurality of grooves shaped thereinto;
wherein the top elongated rods, the middle elongated rods and the bottom elongated rods each has two ends being pivotally connected to the front plate and the rear plate, respectively;
wherein the top elongated rods, the middle elongated rods and the bottom elongated rods each comprises a solid-iron rod enclosed with a cladding layer.

2. The wafer cassette of claim 1, further comprising at least one connecting element by which the middle elongated rod and the bottom elongated rod disposed at the same side are connected together.

3. The wafer cassette of claim 1, further comprising four fastening rods disposed at four corners of the front plate and the rear plate, the four fastening rods each having two ends being pivotally connected to the front plate and the rear plate, respectively.

4. The wafer cassette of claim 1, wherein the cladding layer comprises Polyether ether ketone (PEEK).

5. The wafer cassette of claim 1, wherein a surface of the solid-iron rod is subjected to texture treatment, prior to enclosing the cladding layer.

6. The wafer cassette of claim 1, wherein the solid-iron rod is a polygon solid-iron rod.

7. The wafer cassette of claim 6, wherein the front plate and the rear plate have hollows cut thereinto at places where the top elongated rods, the middle elongated rods and the bottom elongated rods are pivotally connected to the front plate and the rear plate, wherein the hollows have a shape corresponding to a polygon cross section of the polygon solid-iron rod.

8. A method of forming a wafer cassette, comprising:
providing a plurality of solid-iron rods;
enclosing the solid-iron rods with a cladding layer by injection moulding process, thereby resulting at least two top elongated rods, at least two middle elongated rods and at least two bottom elongated rods; and
pivotally connecting two ends of each of the top elongated rods, the middle elongated rods and the bottom elongated rods to a front plate and a rear plate, respectively, the front plate and the rear plate being disposed opposite to face each other.

9. The method of claim 8, wherein the injection moulding process is performed by injecting cladding material over the solid-iron rod into a mould with grooves shape, therefore resulting in a plurality of grooves shaped into the cladding layer.

10. The method of claim 9, wherein the cladding material comprises Polyether ether ketone (PEEK).

11. The method of claim 8, further comprising a step of connecting the middle elongated rod and the bottom elongated rod disposed at the same side by at least one connecting element.

12. The method of claim 8, further comprising a step of pivotally connecting two ends of each of four fastening rods to four corners of the front plate and the rear plate, respectively.

13. The method of claim 8, further comprising a step of subjecting a surface of the solid-iron rod to texture treatment, prior to enclosing the cladding layer.

14. The method of claim 8, wherein the solid-iron rod is a polygon solid-iron rod.

15. The method of claim 14, further comprising a step of cutting hollows into the front plate and the rear plate at places where the top elongated rods, the middle elongated rods and the bottom elongated rods are pivotally connected to the front plate and the rear plate, wherein the hollows have a shape corresponding to a polygon cross section of the polygon solid-iron rod.
